(19) Europäisches Patentamt

European Patent Office

Office européen des brevets

(11) **EP 2 736 044 B1**

(12) # EUROPEAN PATENT SPECIFICATION

(45) Date of publication and mention of the grant of the patent:
**15.11.2017 Bulletin 2017/46**

(51) Int Cl.:
*G11C 11/16* (2006.01)     *G11C 13/00* (2006.01)
*H03K 19/177* (2006.01)

(21) Application number: **12193826.0**

(22) Date of filing: **22.11.2012**

(54) **RRAM IMPLICATION LOGIC GATES**

RRAM IMPLIKATION LOGISCHE GATTER

RRAM PORTES LOGIQUES D'IMPLICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**28.05.2014 Bulletin 2014/22**

(73) Proprietor: **Technische Universität Wien
1040 Wien (AT)**

(72) Inventors:
• **Mahmoudi, Hiwa
1140 Vienna (AT)**
• **Windbacher, Thomas
2722 Winzendorf (AT)**
• **Sverdlov, Viktor
2275 Bernhardsthal (AT)**
• **Selberherr, Siegfried
3430 Tulln (AT)**

(74) Representative: **Puchberger & Partner
Patentanwälte
Reichsratsstraße 13
1010 Wien (AT)**

(56) References cited:
**EP-A2- 1 557 841**

• **HIWA MAHMOUDI ET AL: "MTJ-based implication logic gates and circuit architecture for large-scale spintronic stateful logic systems", 2012 PROCEEDINGS OF THE EUROPEAN SOLID-STATE DEVICE RESEARCH CONFERENCE (ESSDERC), 1 September 2012 (2012-09-01), pages 254-257, XP55059245, DOI: 10.1109/ESSDERC.2012.6343381 ISBN: 978-1-46-731706-1**
• **BORGHETTI J ET AL: "'Memristive' switches enable 'stateful' logic operations via material implication", NATURE: INTERNATIONAL WEEKLY JOURNAL OF SCIENCE, NATURE PUBLISHING GROUP, UNITED KINGDOM, vol. 464, no. 7290, 8 April 2010 (2010-04-08), pages 873-876, XP002608177, ISSN: 0028-0836, DOI: 10.1038/NATURE08940**
• **HIWA MAHMOUDI ET AL: "Implication logic gates using spin-transfer-torque-operated magnetic tunnel junctions for intrinsic logic-in-memory", SOLID-STATE ELECTRONICS, 1 March 2013 (2013-03-01), XP055059088, ISSN: 0038-1101, DOI: 10.1016/j.sse.2013.02.017**

EP 2 736 044 B1

## Description

The invention relates to an electronic circuit comprising a plurality of bit cells arranged in array and being selectable by row lines and column lines, at least one row driver, at least one column driver, and a readout circuit, wherein each bit cell comprises a non-volatile resistive-switching element and an access transistor.

## BACKGROUND

At present, the most commonly used logic circuits consist of a memory unit for data storage and a separate logic unit for holding data and performing arithmetic and logic operations which are typically based on CMOS technology. On one hand, these CMOS-based logic circuits retain information as long as power is applied (volatility) and any power supply interruption can cause loss of information. On the other hand, as the dimensions of the CMOS transistors shrink down the leakage currents increase. As a result, the power consumption is nowadays an important limiting factor in scaling of the CMOS technology. For instance the standby power consumption in CMOS-based logic circuits has become comparable to the dynamic power consumption.

Introducing non-volatility into the circuits for which non-volatile memory elements are distributed among logic gates can solve the standby power problem described before. A configuration which combines logic and memory elements (so-called logic-in-memory), allows shortening interconnection delays by eliminating the need to transfer data into separate memory and logic circuits.

The logic-in-memory circuit disclosed in US 2005/0174837 A1 uses tunnel magnetoresistance (TMR) elements as non-volatile memory devices to provide memory inputs. It realizes the AND operation between one memory input (as stored data) and an external input which is a voltage signal. The operation result is provided by an IV converter as a voltage value.

The problem with this logic-in-memory configuration is that the realized AND operation is volatile and writing the generated output voltage signal into a non-volatile element requires additional circuitry for generating a writing magnetic field which increases delay and complexity. Furthermore, the configuration realizes only an AND operation and cannot perform OR and NOT operations and thus requires at least a CMOS-based NOT operation to be computationally complete.

The logic-in-memory circuit disclosed in US 7221600 B2 uses a variable resistance element as non-volatile memory device to provide a memory input and realizes AND and OR operations for which the memory device can be used also as the output in the case of destructive operations. With this configuration, a logic operation between different memory inputs cannot be performed. Therefore sensing amplifiers are required to read the memory data at each logic stage and providing the next stage with a voltage signal as an external input.

The magneto-logic circuit disclosed in US 7755930 B2 uses a magnetic memory element and a current driving circuit to realize logic operations on a plurality of input values which are voltage signals. The operation output is written into the magnetic memory element by applying a magnetic field generated by a current changing in accordance to the logic states of the input values.

However, a key limitation of these logic circuits is the necessity to have different kinds of inputs and outputs for which some inputs or outputs are voltage signals whereas the others are the resistance state of non-volatile memory elements. This mismatch causes the need for extra hardware including sensing amplifiers to read the memory data at each logic stage and providing the next logic stage with a proper voltage signal as an external input from the output of the previous logic stage. This increases the power consumption, time delay, and complexity.

The document US 8179716 B2 discloses non-volatile logic gates comprising Spin-Transfer Torque (STT)-operated magnetic tunnel junction (STT-MTJ) elements which are used as the main devices for logical computations (intrinsic logic-in-memory) for which the need of extra hardware (CMOS-based logic gates) is eliminated. After performing a logic operation the logic input and output values are stored in the resistance state of the input and output memory elements.

However, the logic inputs are determined by the polarity of the input currents applied to the input MTJ elements. Therefore the logic circuit requires sensing amplifiers to read the output data to provide an input current in proper direction for the next logic stage. Furthermore, the ferromagnetic free layers of the input and the output MTJ elements in each gate must be electrically connected via magnetostatic or physical coupling. This highly localizes the logical computations and limits the possibility of performing logic operations between different inputs MTJs of different gates. Thus, generalization of such non-volatile logic gates to large-scale logic circuits is problematic.

Therefore, in the state of the art, large-scale integration of complex logic functions cannot be realized using the non-volatile logic-in-memory concept due to the need for sensing amplifiers and intermediate circuitry. This causes a lack of flexibility because of hard linking between the inputs and output memory elements in a particular gate.

The document XP-55059245 "MTJ-based implication logic gates and circuit architecture for large-scale spintronic stateful logic systems" shows an electronic memory circuit wherein each bit cell makes use uf a non-volatile resistive-switching element. However, this circuit does not allow to perform an implication type logic operation between bit cells of two different row lines without requiring work cells, and therefore requires an increased footprint. The documents EP 1 557 841 A2 and XP-002608177 "Memristive switches enable stateful logic operations via material implication" also show electronic circuits applying non-volatile resistive-switching elements.

Therefore, the object of the invention is to provide an electronic circuit that combines the features of resistive memory devices with the features of logic devices, to enable the construction of a logic-memory-circuit that can execute logic operations without the need of adding conventional logic gates, sensor devices, or amplifiers, and which offers the possibility to perform an implication type logic operation between bit cells of different row lines without increasing the required footprint.

SUMMARY OF THE INVENTION

To overcome the above-described problems, this invention discloses an electronic circuit according to claim 1.

Based on the presented electronic circuit, it is possible to extend the functionality of a common non-volatile resistive memory to include performing logic operations for which the need for sensing amplifiers and distributing logic devices over the memory block is eliminated. Memory elements at different locations can be used to construct logic gates. Therefore the logical computation is not localized and fewer elements are required to realize logical functions. Due to non-local logic implementation on one hand and being computationally complete on the other hand, the disclosed logic-in-memory circuit is highly flexible and suited for large-scale non-volatile logic systems.

Furthermore, unlike the state-of-the-art logic-in-memory circuits, the disclosed logic-in-memory can use any memory element as both input and output element and offers an efficient, flexible, and simple circuit structure suited for large-scale non-volatile logic systems, which allows shortening interconnection delays and opens the door for innovations in computational paradigms by shifting away from the Von Neumann architecture.

According to the invention, the source bit cell modulates the current or voltage required to reach a critical current or voltage to switch a full-selected bit cell (target bit cell). The result depends on the initial state of the target bit cell. Depending on the initial states of both the source and the target bit cells a switching event is enforced to the target bit cell (desired switching event) or not.

A desired switching event is a high-to-low switching event which is enforced to the target bit cell only when both target and source resistive-switching elements are initially at high resistance states and for all three other possible combinations of the initial resistance states, both target and source resistive-switching elements are left unchanged and there is no undesired switching event. This initial state dependent switching corresponds to the basic Boolean operations called IMPLIES (IMP) and NOT IMPLIES (NIMP, negated IMP).

The initial logic state of the source and target bit cells act as the inputs and the final logic state of the target bit cell is the output of the logic operation. In combination with a writing operation (low-to-high resistance switching), the material implication forms a complete logic basis to compute any Boolean function.

The resistive-switching element according to the invention might require a critical current or voltage for switching between the high and the low resistance states. The switching of the resistance state can also be performed by a current pulse of sufficient duration. It can be provided that the resistive-switching element has a distinct low resistance state and a distinct high resistance state.

Respective resistive-switching devices could be realised, for example, as capacitor-like devices such as metal-oxide-interface which show oxygen ion/vacancy migration and formation/annihilation at the interface, phase change memory devices, or electron spin junctions. Some resistive-switching devices show a continuous change in resistance, for example a TiO2 memristive switch was shown where the resistance can be equal to any value between 100 Ohm and 10 kOhm. According to the invention, any resistive-switching device can be used which has at least two resistance states (low and high) configured for storing binary data and requires a critical current or voltage for switching between the high and low resistance states.

A resistive-switching device according to the invention can be unipolar or bipolar. For unipolar switching mechanism the low-to-high or high-to-low switching can occur both at the positive and negative current or voltage polarities and only the amplitude of the applied signal is important.

For bipolar switching in can be provided that the resistance state of the resistive-switching elements is changed from a first state to a second state by a current or voltage impulse in a first direction, and from the second state to the first state by a current or voltage impulse in the opposite direction, where a critical current $I\_H$-to-L or critical voltage has to be applied for switching. The applied current or voltage can change the polarity to switch between different resistance states and the positive and negative signals may have the same (symmetric switching characteristics) or different (asymmetric switching characteristics) amplitudes.

It may be provided within the scope of the invention that the resistive-switching element has an asymmetric switching characteristic and the logic current $I\_imp$ has the same polarity as the current $I\_H$-to-L required to switch the resistive-switching element.

It can further be provided that the resistive-switching element has a unipolar switching characteristic so that the resistance state of the resistive-switching elements is changed from a first state to a second state by a current or voltage of a first amplitude, and from the second state to the first state by a current or voltage impulse of a second amplitude, where a critical current I_H-to-L or critical voltage has to be applied for switching.

Preferably, the logic current I_imp can have an amplitude higher than the critical current I_H-to-L to enforce a desired switching event in the resistive-switching element of the target bit cell but small enough to prevent undesired switching events of the source or the target bit cell. The ratio of the current I_imp to the current I_H-to-L required to switch the resistive-switching element can preferably be between 1 and 2.

The logic current I_imp can also have the same amplitude as the current I_H-to-L and be applied at a pulse duration that is long enough to enforce a desired switching event in the resistive-switching element of the target bit cell and short enough to prevent undesired switching events of the source or the target bit cell. Preferably, the current pulse I_imp can be applied at a pulse duration that is 2 - 3 orders of magnitude longer than the pulse duration of the current I_H-to-L. To avoid undesired switching events, there can be a particular range for the amplitude and/or the pulse duration of the logic current I_imp.

The resistive-switching elements can be realized as magnetic tunnel junction (MTJ) devices, preferably Spin-Transfer-Torque (STT) MTJ devices, and the access transistors as conventional CMOS transistors.

The invention further relates to a method to perform the logic operation material implication (IMP) or negated material implication (NIMP) on a non-volatile resistive memory array according to claim 11.

The logic current I_imp can have a higher amplitude than a critical current I_H-to-L required to switch the resistive-switching element of the target bit cell from a high resistance state to a low resistance state but small enough to prevent undesired switching events. Preferably, the ratio of the current I_imp to the current I_H-to-L can be between 1 and 2.

The logic current I_imp can also be applied at a pulse duration that is long enough to enforce a desired switching event in the resistive-switching element of the target bit cell, but still short enough to prevent undesired switching events. Preferably, the current pulse I_imp can be applied at a pulse duration that is 2-3 orders of magnitude longer than the pulse duration of the current I_H-to-L.

In a memory mode, the above mentioned logic-in-memory array utilizes the access transistors as on/off switches to read/write any bit cell. In a logic mode, an access transistor is used as a voltage-controlled resistor to pre-select a bit cell which acts as an input bit cell (source bit cell).

BRIEF DESCRIPTION OF THE DRAWINGS

FIG. 1A     is a diagram of a common logic circuit comprising memory and logic units,

FIG. 1B     is a diagram of a common logic-in-memory circuit,

FIG. 2     is a diagram of a common magnetic memory using spin transfer torque magnetoresistive random-access memory (STT-MRAM) technology,

FIG. 3     is a diagram depicting one embodiment of an intrinsic logic-in-memory array in accordance with the present invention,

FIG. 4A     is a truth table of the realized basic logic operation NIMP using the intrinsic logic-in-memory circuit in accordance with the present invention,

FIG. 4B     is a graph illustrating the high-to-low resistance switching dynamics of a resistive-switching element according to the invention,

FIG. 5A     is a table showing subsequent steps required for performing the universal logic operation NOR in the logic-in-memory circuit according to the invention,

FIG. 5B     is a truth table of the three-step process to perform the universal NOR operation in the intrinsic logic-in-memory circuit in accordance with the present invention,

FIG. 6A     is a truth table of the realized basic logic operation IMP using the intrinsic logic-in-memory circuit in accordance with the present invention,

FIG. 6B is a truth table of the three-step process to perform the universal NAND operation in accordance with the present invention,

FIG. 7 is a diagram depicting a further embodiment of an intrinsic logic-in-MRAM (magnetoresistive random-access memory) using spin-transfer torque (STT) switching technology (STT-MRAM) according to the invention.

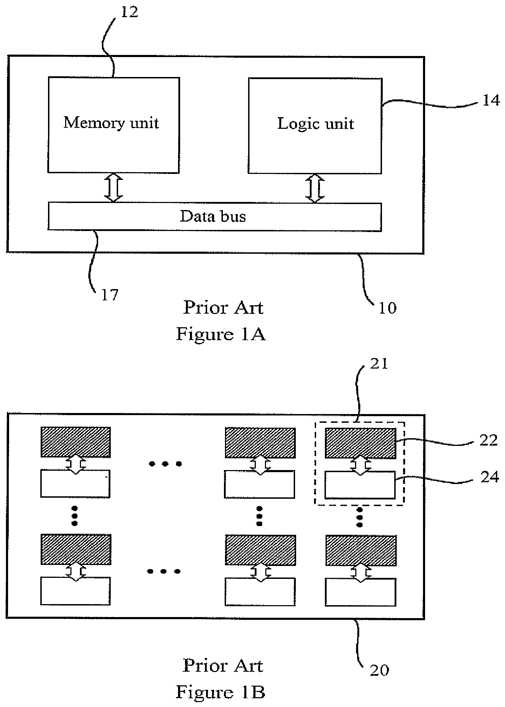

FIG. 1A shows a state-of-the-art logic circuit 10 including a logic unit 14 and a memory unit 12 which are connected through a data bus 17. The logical process in logic circuit 10 is performed by reading the data out from the memory unit 12 and transferring the data to the logic unit 14 through the data bus 17, performing logic operations in the logic unit 14, and transferring the operation results back to the memory unit 12 through the data bus 17. As more data has to be transferred in shorter time, the data bus turns out to be a major performance-limiting bottle neck of such a structure. In addition to that, leakage currents due to shrinking feature size of common CMOS components has become a top concern of the logic circuits used.

Logic-in-memory circuits have been proposed to solve this issue. In the state-of-the-art logic-in-memory circuit 20 shown in FIG. 1B, non-volatile memory elements 22 are distributed among logical elements 24 to construct local logical sub-circuits 21. This architecture can significantly reduce the standby power by holding the information in non-volatile memory elements. Refreshing pulses, which are critical for CMOS-based storage elements, can be avoided. Furthermore, the short data transfer path between the memory element 22 and the adjacent logical element 24 can significantly reduce the data transfer time and the data traffic on a main bus like the data bus 17, so that in effect interconnection delays are reduced. As a non-volatile technology, the magnetic tunnel junction (MTJ) is very promising for logic-in-memory circuits since it is CMOS-compatible, fast, low power, highly scalable and has excellent endurance. However, in the logic-in-memory circuit 20 the non-volatile memory elements (for example MTJs) are used only as ancillary devices for logical computations. They require readout schemes for reading the stored logical data as well as properly adjusted current or voltage signal levels to function with the logical elements 24. A seamless integration with the logical elements 24 is not possible. This limitation increases complexity, delay, and power consumption. Furthermore, as the logical computations are localized, the generalization of the common logic-in-memory circuits to large-scale logic systems is complicated.

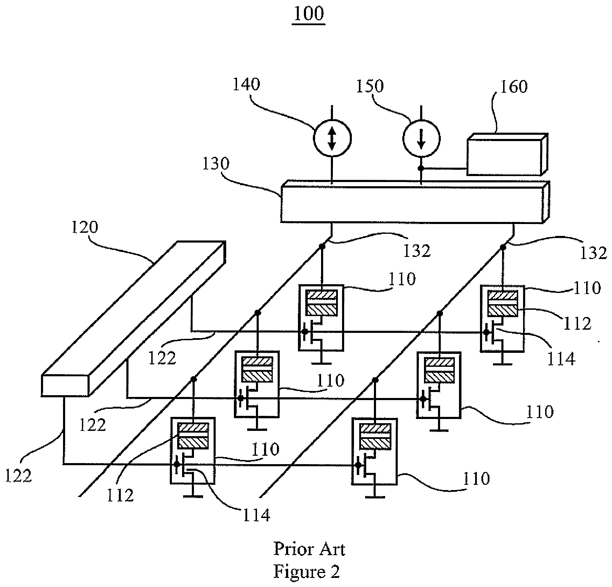

FIG. 2 shows a diagram of a state-of-the-art magnetic non-volatile memory array using Spin-Transfer Torque (STT) Magnetoresistive Random-Access Memory (MRAM) technology. The electronic circuit 100 comprises a plurality of non-volatile bit cells 110 coupled to a column driver 130 through a plurality of column lines 132. Each bit cell 110 comprises a resistive-switching element 112 configured to store binary data and an access transistor 114 coupled in series. The resistive-switching element 112 is provided as a magnetic tunnel junction (MTJ) device, and the access transistor 114 as a CMOS (complementary metal-oxide semiconductor) transistor. In general, an MTJ element includes at least one ferromagnetic free layer and a ferromagnetic pinned layer separated by a nonmagnetic barrier layer. The electrical resistance of the MTJ element is low (high) when the magnetization directions of the free layer and pinned layer are parallel (antiparallel). In STT-MRAM technology, the free layer of the MTJ element switches from parallel to antiparallel alignment (or vice-versa) compared with the pinned layer when the torque exerted by spin-polarized electrons passing through the MTJ element (spin transfer torque) exceeds a threshold value. The access transistors 114 act as on/off switches which control the current flowing through the resistive-switching elements 112. The gate terminals of the access transistors are coupled to a row driver 120 via row lines 122 for applying proper voltage signals to switch on the access transistors 114 to select the resistive-switching elements 112 in a desired row for reading and writing operations.

During a reading operation, the row driver 120 selects the desired row line 122 and the column driver 130 applies a read current 150 (I_rd) to the desired column line 132 which will flow through the desired bit cell 110. Depending on the binary data stored in the desired bit cell 110, the desired resistive-switching element 112 is in a high or low resistance state. A readout circuit 160 is provided to read the logical value stored in the selected bit cell by sensing the generated voltage difference on the column line 132. The read current (I_rd) 150 must be low enough to prevent a read disturbance which results in an undesired switching.

During a writing operation, the row driver 120 selects the desired row line 122 and the column driver 130 applies a write current 140 to the desired column line 132 which will flow through the desired bit cell 110.

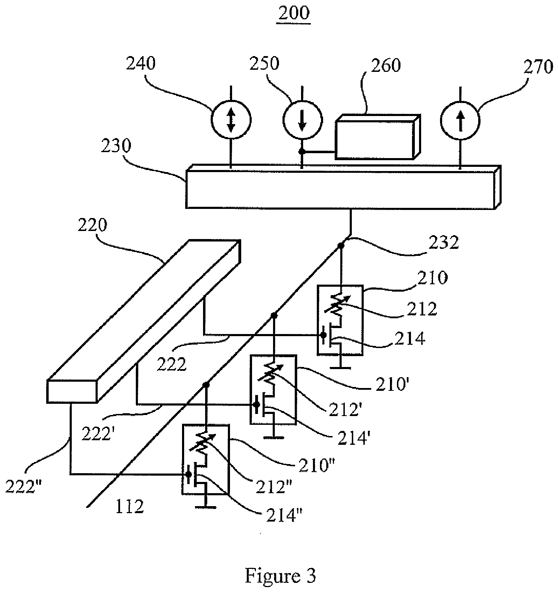

The write current is denominated I_H-to-L for high-to-low resistance switching or I_L-to-H for low-to-high resistance switching, depending on the desired binary data (logical 1 or 0) which should be written in the desired bit cell. FIG. 3 illustrates an intrinsic logic-in-memory array in accordance with the present invention. The electronic circuit 200 comprises a plurality of non-volatile bit cells 210 coupled to a column driver 230 through a current carrying column line 232. Each bit cell 210 comprises a resistive-switching element 212 configured to store binary data and an access transistor 214 coupled in series. The resistive-switching element 212 is a two terminal device which has a variable resistance and the logical data can be stored in its low resistance state (LRS) or high resistance state (HRS).

A sufficiently high enough current or voltage in a first direction can switch the resistive-switching element to LRS. If applied in a second direction, a sufficiently high enough current or voltage puts the resistive-switching element in HRS. The resistive-switching element requires a critical current or voltage for switching and, for example, it can be a STT-MTJ, a phase-change memory, or a memristive switch based on ionic transport in a metal/oxide/metal structure, etc. For a resistive-switching element with bipolar switching characteristic (such as a STT-MTJ) the first and the second critical currents or voltages for LRS and HRS switchings have the opposite direction. The resistive-switching element may require the same (symmetric switching) or different (asymmetric switching) current or voltage pulse amplitudes for LRS and HRS switchings. For a resistive-switching element with unipolar switching characteristic (such as a phase-change memory) the first and the second critical currents or voltages for LRS and HRS switchings have different pulse amplitudes but can be in the same or in the opposite direction.

In a further embodiment of the invention not shown, the resistive-switching element can be switched from the LRS to the HRS by a current pulse of a specific first duration, and from the HRS to the LRS by a current pulse of a specific second duration different from the first duration.

The access transistor 214 controls the current which passes through the resistive-switching element 212.

The gate of the access transistor is coupled to a row driver 220 via a row line 222 for selecting or pre-selecting bit cells in a row line in order to read, write, or perform a logic operation. For reading the logical data stored in a bit cell 210', the row driver 220 selects the access transistor 214' by applying a select voltage V_s to the row line 222' and the column driver 230 drives a read current 250 to the column line 232. The read current 250 flows through the bit cell 210'. Depending on the binary data stored in the selected bit cell, the resistive-switching element 212' is in the high or low resistance state. Therefore a readout circuit 260 can detect the data by sensing the generated voltage difference on the column line 232. The read current 250 must be low enough to prevent a read disturbance which for example can be an undesired switching.

For writing logical data into a desired bit cell, for example bit cell 210', the row driver 230 selects the access transistor 214' by applying a select voltage V_s to the row line 222' and the column driver 230 applies a write current 240 to the column line 232. The write current 240 then flows through the bit cell 210'. The write current 240 can be of a first value I_H-to-L in a first direction for high-to-low resistance switching or of a second value I_L-to-H in the second direction for low-to-high resistance switching, depending on the binary data that shall be written.

In an embodiment not shown, the write current 240 is applied for a specific pulse duration to perform the switching of the bit cell 210'.

For performing the logic operation NIMP, the row driver 220 selects simultaneously a desired target bit cell 210 and pre-selects a desired source bit cell 210', and the column driver 230 applies a logic current 270 (further denominated as I_imp) to the column line 232. The logic current 270 has a higher amplitude than I_H-to-L and has the same polarity.

The row driver 220 utilizes the access transistors 214, 214' as voltage-controlled resistors and applies a first (selecting) voltage V_s or a second (pre-selecting) voltage V_p-s to any row line. The voltage V_s is higher than that of V_p-s. Therefore, the resistance of the selected transistor 214 is smaller than the resistance of the pre-selected transistor 214'.

The logic current 270 therefore divides between the target bit cell 210 and the source bit cell 210' and is inversely proportional to the total resistance of each bit cell 210, 210'. The total resistance of each bit cell 210, 210' is the sum of the resistances of the access transistors 214, 214' and the resistive-switching elements 212, 212'.

Since the resistance values of the resistive-switching elements 212, 212' depend on the stored logical values, the current division between the target bit cell 210 and the source bit cell 210' will depend on the logic states of the bit cells 210, 210'. Because the logic current 270 has the same polarity and a higher amplitude as I_H-to-L, it tends to put both selected and pre-selected resistive-switching elements 212, 212' into the low resistance state.

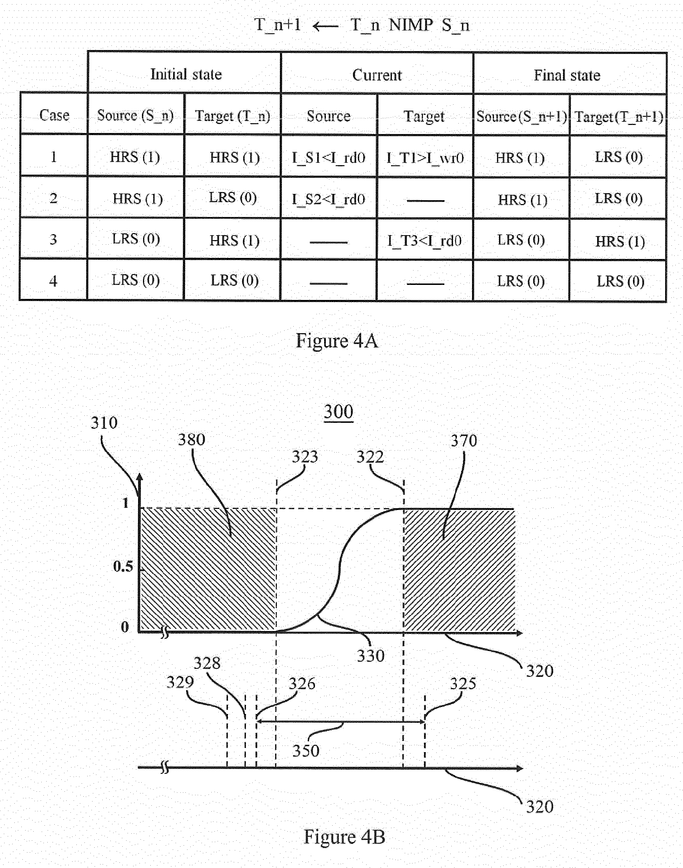

Fig. 4A shows a state diagram of the logic states of the source bit cell 212' (Source S_n) and the target bit cell 212 (Target T_n). Both bit cells can either be in a high resistance state (HRS, corresponding to a logic "1") or in a low resistance state (LRS, corresponding to a logic "0").

The cases 1 to 4 correspond to the 4 different initial states based on the initial resistance (logic) states. Depending on the current level through the target bit cell I_T1, I_T3, it switches from its initial states to its final states. The conditional switching behavior realizes a logic operation shown in Fig. 4A. The different switching events will be discussed below together with the discussion of the switching dynamics in Fig. 4B.

FIG. 4B shows the switching dynamics of a resistive-switching element according to the invention as a function of the current or voltage pulse amplitude. In FIG. 4B the horizontal axis 320 shows the current (or voltage) level applied to a resistive-switching element for a given time (equal to the pulse duration). The solid curve 330 indicates the high-to-low resistance switching dynamics of the resistive-switching element.

The vertical axis 310 represents the switching probabilities for a particular resistive-switching element (a STT-MTJ) with a stochastic switching model or a normalized internal state variable of the resistive-switching element (a metal/oxide/metal memristive switch) with a deterministic switching model.

On the right hand side, for the reliable switching region 370, the dashed line 322 represents the minimum reliable switching current (I_wr0) or a corresponding voltage. On the left hand side, the reliable non-switching region 380, the dashed line 323 represents the maximum reliable non-switching current (I_rd0) or a corresponding voltage.

The maximum reliable non-switching current can be seen as the maximum current which does not cause an undesired switching event or a reading disturbance.

The logic current 270 (I_imp) divides between the target bit cell 210 and the source bit cell 210' as:

$$I\_imp = I\_Ti + I\_Si$$

$$I\_Ti = R\_Si \ (I\_imp/ \ R\_Ti + R\_Si)$$

$$I\_Si = R\_Ti \ (I\_imp/ \ R\_Ti + R\_Si)$$

I_Ti and I_Si are the currents passing through the target bit cell 210 and the source bit cell 210', respectively. R_Ti and R_Si are the total resistances of the target bit cell 210 and the source bit cell 210', respectively. Depending on the initial states, i indicates the Case number which can be 1, 2, 3, or 4 as shown in FIG. 4A. Since the logic current 270 has the same polarity as I_H-to-L, I_Ti and I_Si, it tends to put the target resistive-switching element 212 and the source resistive-switching element 212' into the low resistance state.

As shown in FIG. 4A, the source resistive-switching element 212' is already in the low resistance state in Case 3 and Case 4. Therefore a switching event in the source resistive-switching element 212' can only be enforced in Case 1 and Case 2, when the source resistive-switching element 212' is in the high resistance state. Since the source access transistor 214' is pre-selected, and the pre-selecting voltage V_p-s is lower than the selecting voltage V_s, its resistance is high. Therefore the currents passing through the source bit cell 210' in Case 1 (I_S1; source bit cell current 328) and Case 2 (I_S2; source bit cell current 329) are lower than the maximum reliable non-switching current 323 (I_rd0). No switching can occur. Thus in all Cases 1 - 4 the source resistive-switching element 212' is left unchanged.

The target resistive-switching element 212 is initially in a low resistance state in Case 2 and Case 4, therefore I_Ti can enforce a switching event to the low resistance state only in Case 1 and Case 3.

The difference between the currents passing through the target resistive-switching element 212 in Case 1 and Case 3, I_T1 and I_T3, is caused by the difference between the initial resistance states of the source resistive-switching element 212'. In Case 1 the source access transistor 214' is pre-selected and also the source resistive-switching element 212' is in its high resistance state.

Therefore the total resistance of the source bit cell 210' (R_S1) is higher than the total resistance of the target bit cell 210 (R_T1), so the majority of the logic current 270 (I_imp) flows through the target bit cell 210. The target bit cell current I_T1 is higher than the source bit cell current I_S1.

The target bit cell current I_T1 (reference numeral 325 in FIG. 4B) is higher than the minimum reliable switching current 322 (I_wr0) and it enforces a high-to-low resistance switching event in the target bit cell 210. During the switching the resistance of the target resistive-switching element 212 decreases while the resistance of the source resistive-switching element 212' remains unchanged. Therefore the current passing through the target resistive-switching element 212 (I_T1) increases. This generates a positive feedback which accelerates the switching.

In Case 3, although the source access transistor 214' is pre-selected, the source resistive-switching element 212' is in low resistance state. Therefore the current passing through the source bit cell 210' is higher as compared to Case 1 (I_S3>I_S1). This decreases the current I_T3 passing through the target bit cell 210 (reference numeral 326 in FIG. 4B) below the maximum reliable non-switching current 323 (I_T3<I_rd0).

This state dependent modulation of the current passing through the target bit cell 210 (double arrow 350 in FIG. 4B) realizes a conditional switching behavior which is equivalent to the basic logic operation shown in FIG. 4A. In combination with the low-to-high resistance state switching (writing logical 1; the operation TRUE), the realized logic operation is called NIMP (NOT IMPLIES) and forms a complete logic basis to compute any other Boolean function.

Since the electronic circuit 200 is realized as a logic-in-memory circuit, the final states of the source and target bit cells 210', 210 can be directly used for storing logic data. There is no interface or driver electronics necessary, as in conventional memory circuits that are coupled to logic devices. Instead of first fetching an initial state from memory, computing the logic operation, and writing back the final state to memory, the logic operation is directly performed on the memory itself. Fetching and writing back becomes obsolete.

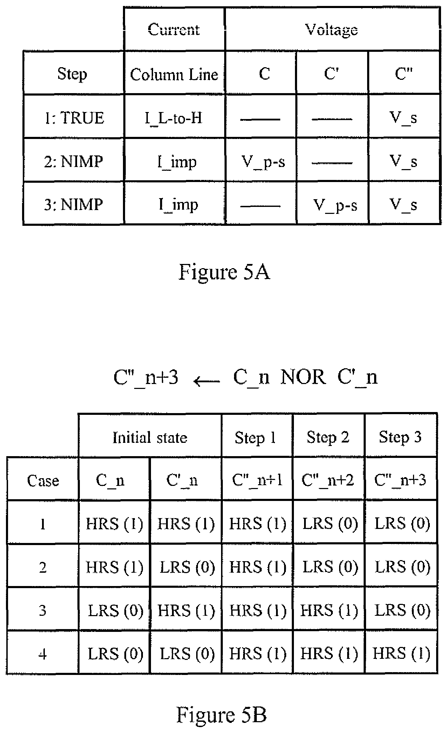

FIG. 5A shows a three-step implementation of the universal logic operation NOR using sequential TRUE and NIMP operations on three arbitrary bit cells like 210, 210', and 210" containing the logical values C, C', and C", respectively. In Step 1, the low-to-high resistance state switching is executed on the bit cell 210" by applying the current I_L-to-H to the bit line 232 and the selecting voltage V_s to the gate terminal of the access transistor 214".

In Step 2, the operation NIMP is executed between the bit cell 210 and 210" by applying the current 270 (I_imp) to the bit line 232, the pre-selecting voltage V_p-s to the access transistor 214, and the selecting voltage V_s to the access transistor 214". Therefore, 210 and 210" act as the source and the target bit cells, respectively, and the operation result will be written in 210".

In Step 3, the operation NIMP is executed between the bit cell 210' and 210" by applying the current 270 (I_imp) to the bit line 232, the pre-selecting voltage V_p-s to the access transistor 214', and the selecting voltage V_s to the access transistor 214".

Therefore, 210' and 210" act as the source and the target bit cells, respectively, and the final result will be written in 210". The final result is equivalent to the NOR operation between 210 and 210'. Since the operation NOR is a universal logic operation, any Boolean function can be performed by using a combination of NIMP and TRUE operations.

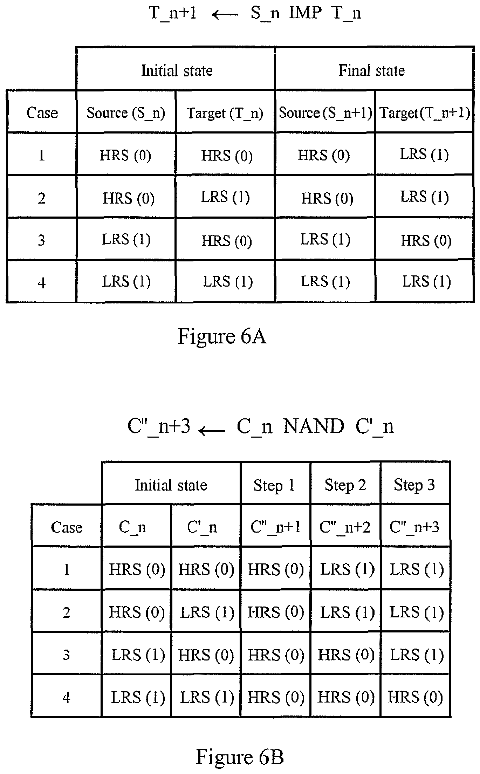

Opposite to the conventional definition, if the high and low resistance states (HRS and LRS) are defined as logical 0 and 1, the basic logic operation described in FIG. 4A will be equivalent to the fundamental logic operation IMP (IMPLIES) as shown in FIG. 6A (T_n+1 ← S_n IMP T_n). With this definition, the low-to-high resistance switching is equivalent to writing logical 0 (operation FALSE). In combination with FALSE, the operation IMP forms a complete logic basis to compute any Boolean function. With this definition, subsequent operations described in FIG. 5B will be corresponding to the universal NAND operation between 210 and 210' as shown in FIG. 6B.

As an example of the generalization of the intrinsic logic-in-memory array 200 to an intrinsic logic-in-random-access memory (logic-in-RAM) circuit by using STT-MTJs as non-volatile resistive-switching elements, the common STT-MRAM 100 can be upgraded to a logic-in-STT-MRAM (or briefly logic-in-MRAM) architecture with no need to add CMOS-based logic gates, arithmetic circuits, or buses.

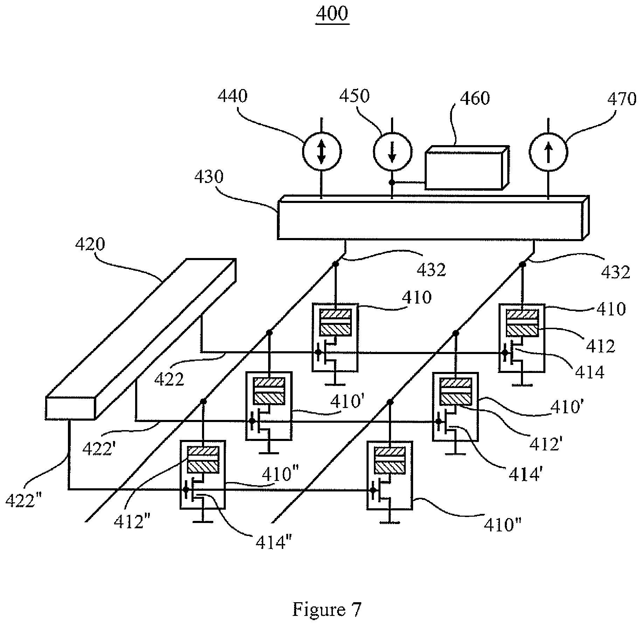

FIG. 7 shows an intrinsic logic-in-MRAM circuit using STT-MRAM technology based on the intrinsic logic-in-memory array in accordance with the present invention. The electronic circuit 400 comprises a plurality of intrinsic logic-in-memory arrays coupled to a column driver 430 through a plurality of current carrying column lines 432. Each intrinsic logic-in-memory array comprises a plurality of non-volatile bit cells 410 for which each bit cell 410 comprises a resistive-switching element 412 realized as STT-MTJ element and an access transistor 414 realized as CMOS transistor coupled in series.

In the electronic circuit 400, similar to the electronic circuit 100 which acted as an electronic memory circuit and the electronic circuit 200 which acted as an intrinsic logic-in-memory array, the reading and writing operations of desired bit cells 410 can be performed by selecting the desired row using the row driver 420 through the desired row line 420 and applying the proper current pulse to the desired column line 432.

Since by selecting the desired row all access transistors 414 in the row are selected, parallel reading and writing operations are possible, if the column driver 430 can apply proper current pulses to more than one column at the same time and the readout circuit 460 can sense the voltage differences generated on all the columns simultaneously. For performing the basic logic operation (IMP or NIMP) in accordance with the present invention, similar to the electronic circuit 200, the row driver 420 selects a desired row as the target row by applying the select voltage V_s and pre-select another desired row as the source row by applying the pre-select voltage V_p-s simultaneously, and the column driver 430 applies the logic current 470 (I_imp) to a desired column line 432. Since by selecting and pre-selecting the as target and source rows all access transistors in the rows are selected and pre-selected, respectively.

In the electronic circuit 400, since each row line gate terminals of the access transistors are coupled, parallel logic implementation in the columns is achieved if the column driver 430 applies logic current pulses I_imp to more than one column at the same time.

From a circuit point of view, the electrical signals required for performing the logic operation IMP or NIMP in a logic-in-MRAM circuit depends on the material composition, geometry, processing, layout/design, and so on. They are chosen based on experimental data for which the logic error Er_imp, defined as $Er\_imp = 1-P\_T1 + P\_S1 + P\_S2 + P\_T3$ is minimized. Here, P_T1 is the switching probability of the target MTJ in Case 1 (desired switching even) which goes to unity, and P_S1, P_S2, and P_T3 are the switching probabilities of the source and target bit cells in Case 1, 2, and 3, respectively (undesired switching events) which go to zero.

Exemplary electrical data are discussed below for an exemplary embodiment of a logic-in-MRAM according to the invention, based on a one-transistor/one-MTJ (1T/1MTJ) state-of-the-art structure fabricated using 0.18 $\mu$m CMOS technology with a 4 level metal for tailored MTJ which has an oval shape of 115x155 nm including an anti-ferromagnetic (AF) pinning layer, a synthetic anti-ferromagnetic pinned layer, a tunnel barrier MgO layer, and a free magnetic layer, as reported by M. Hosomi et al., "A novel nonvolatile memory with spin torque transfer magnetization switching: spin-ram," Proc. IEDM, 2005.

The relationship between the critical switching current I_C and the pulse duration T for pulse duration between 10 ns and 100 us is found to be $T=T\_0 \exp[E/KT \times (1-I\_C/I\_C0)]$, where T_0 is 1 ns, E is the energetic barrier height, and I_C0 is the critical switching current extrapolated to 1 ns.

For writing operations with a pulse duration between 10ns and 100 ns, a selecting voltage V_s in the range of 1.2 to 1.6 V should be applied to a row line 422 and a writing current pulse 440 in the range of 200 to 300 uA should be applied to a column line 432 in a first direction for high-to-low resistance switching (I_H-to-L) or a writing current pulse 440 in the range of 300 to 400 uA should be applied to the column line 432 in the opposite direction for low-to-high resistance switching (I_L-to-H).

For performing logic with a pulse duration between 10ns and 100 ns, a selecting voltage V_s in the range of 1.2 to 1.6 V should be applied to a first word line 422 to select a target bit cell, a pre-selecting voltage V_p-s in the range of 0.6 to 0.8 V should be applied to a second row line 422 to pre-select a source bit cell, and a logic current I_imp in the range of 340uA to 510uA should be applied to at least one column line 432. In order to compensate the current passing through the source bit cell, the logic current I_imp has a higher amplitude than the writing current I_H-to-L when they have the same pulse durations of 10ns to 100 ns.

For performing logic, when the logic current I_imp has the same pulse amplitudes as the writing current I_H-to-L, a pulse duration of 10us to 100us is required which is about 3 orders of magnitude higher than the pulse durations required for the writing operations. In fact at the cost of exponentially increasing the pulse duration, the pulse amplitude can be decreased.

From the device point of view, the tunneling magnetoresistance (TMR) ratio of the MTJ device is the most important parameter for reliability. It can be shown that for optimized electric signals, the Er_imp decreases exponentially with increasing the TMR ratio. For a TMR ratio higher than 250% the error is Er_imp<0.001 which means the desired switching probability P_T1 is higher than 99.9% and the undesired switching probability P_S1 , P_S2 , and P_T3 are lower than 0.1%. The theoretical maximum TMR ratio is about 1000% and the highest TMR ratio obtained so far for MgO-barrier MTJs is about 500% which decreases the error to Er_mp<0.00001.

The invention is not limited to the described embodiments, but comprises as well further embodiments that fall within the scope of the claims. Individual features and characteristics of the invention shown in particular embodiments can be combined and the invention is not limited to the particular embodiments. In particular, the invention is not limited to a specific kind of non-volatile resistive-switching memory element or access transistor, as well as to a specific circuit layout or electrical signal range.

The work leading to this invention has received funding from the European Research Council under the European Union's Seventh Framework Programme (FP7/2007-2013) /ERC grant agreement n° 247056 MOSILSPIN.

List of reference numerals

| 10 | Logic circuit |
| 12 | Memory unit |
| 14 | Logic unit |
| 17 | Data bus |
| 20 | Logic-in-memory circuit |
| 21 | Logical sub-circuit |
| 22 | Non-volatile memory element |
| 24 | Logical element |

| 100, 200, 400 | Electronic circuit |
| 110, 210, 210', 210", 410, 410', 410" | Bit cell |
| 112, 212, 212', 212", 412, 412', 412" | Resistive-switching element |
| 114, 214, 214', 214", 414, 414', 414" | Access transistor |
| 120, 220, 420 | Row driver |
| 122, 222, 222', 222", 422, 422', 422" | Row line |
| 130, 230, 430 | Column driver |
| 132, 232, 432 | Column line |
| 140, 240, 440 | Write current |
| 150, 250, 450 | Read current |
| 160, 260, 460 | Readout circuit |

| 270, 470 | Logic current |

| 300 | State diagram |
| 310 | Switching probability |
| 320 | Current or voltage level applied |
| 322 | Minimum reliable switching current I_wr0 |
| 323 | Maximum reliable non-switching current I_rd0 |

325 Target bit cell current I_T1
326 Target bit cell current I_T3
328 Source bit cell current I_S1
329 Source bit cell current I_S2
330 High-to-low resistance switching dynamics
350 Modulation of target bit cell current
370 Reliable switching region
380 Reliable non-switching region

**Claims**

1. Electronic circuit (200, 400) comprising a plurality of bit cells (210, 410) arranged in an array and being selectable by row lines (222, 422) and column lines (232, 432), at least one row driver (220, 420), at least one column driver (230, 430), and a readout circuit (260, 460), wherein each bit cell (210, 410) comprises an access transistor (214, 414) and a non-volatile resistive-switching element (212, 412) with at least two resistance states, said access transistor and non-volatile resistive-switching element being connected in series to a corresponding column line and a control gate of said access transistor is connected to a corresponding row line,
   wherein in order to write a new data (T_n+1) in a target bit cell, said new data depending on a data (S_n) of a source bit cell (S) and on a data (T_n) stored by the target bit cell (T) before said writing,
   the row driver (220, 420) is capable to simultaneously apply a first selecting voltage (V_s) to a first row line (222, 422) to select the target bit cell (210, 410, T), and a second selecting voltage (V_p-s) to a second row line (222', 422') to select the source bit cell (210', 410', S), and the column driver (230, 430) is capable to apply at the same time a logic current (I_imp) to at least one column line (232, 432),
   **characterized in that**
   the first selecting voltage is different from the second selecting voltage, such that when applied to the first and second row line respectively, the access transistor of the target bit cell has a lower resistance than the access transistor of the source bit cell.

2. Electronic circuit (200, 400) according to claim 1, **characterized in that** the resistive-switching element (212, 412) has a low resistance state and a high resistance state.

3. Electronic circuit (200, 400) according to any of the preceding claims, **characterized in that** the resistive-switching element (212, 412) has a bipolar switching characteristic so that the resistance state of the resistive-switching elements (212, 412) is changed from a first state to a second state by a current or voltage impulse in a first direction, and from the second state to the first state by a current or voltage impulse in the opposite direction, where a critical current (I_H-to-L) or critical voltage has to be applied for switching.

4. Electronic circuit according to claim 3, **characterized in that** the resistive-switching element (212, 412) has an asymmetric switching characteristic and the logic current (I_imp) has the same polarity as the critical current (I_H-to-L) required to switch the resistive-switching element (212, 412).

5. Electronic circuit (200, 400) according to claims 1 or 2, **characterized in that** the resistive-switching element (212, 412) has a unipolar switching characteristic so that the resistance state of the resistive-switching elements (212, 412) is changed from a first state to a second state by a current or voltage of a first amplitude, and from the second state to the first state by a current or voltage impulse of a second amplitude, where a critical current (I_H-to-L) or critical voltage has to be applied for switching.

6. Electronic circuit according to any of the claims 3 to 5, **characterized in that** the logic current (I_imp) has an amplitude higher than the critical current (I_H-to-L) to enforce a desired switching event in the resistive-switching element (212, 412) of the target bit cell but small enough to prevent undesired switching events of the source or the target bit cell.

7. Electronic circuit according to claim 6, **characterized in that** the ratio of the logic current (I_imp) to the critical current (I_H-to-L) required to switch the resistive-switching element (212, 412) is between 1 and 2.

8. Electronic circuit according to any of the claims 3 to 5, **characterized in that** the logic current (I_imp) has the same amplitude as the critical current (I_H-to-L) and is applied at a pulse duration that is long enough to enforce a desired switching event in the resistive-switching element (212, 412) of the target bit cell and short enough to prevent undesired switching events of the source or the target bit cell.

9. Electronic circuit according to claim 8, **characterized in that** the logic current pulse (I_imp) is applied at a pulse duration that is 2 - 3 orders of magnitude longer than the pulse duration of the critical current (I_H-to-L).

10. Electronic circuit according to any of the preceding claims, **characterized in that** the resistive-switching elements (212, 412) are magnetic tunnel junction (MTJ) devices, preferably Spin-Transfer-Torque (STT) MTJ devices, and the access transistors (214, 414) are CMOS transistors.

11. Method to perform the logic operation material implication (IMP) or negated material implication (NIMP) on a non-volatile resistive memory array comprising a plurality of bit cells (210, 410) being selectable by row lines (222, 422) and column lines (232, 432), wherein each bit cell (210, 410) comprises a non-volatile resistive-switching element (212, 412) with at least two resistance states, and an access transistor (214, 414), at least one row driver (220, 420), at least one column driver (230, 430), and a readout circuit (260, 460), and wherein, for each bit cell (210, 410), the corresponding access transistor and non-volatile resistive-switching element are connected in series to a corresponding column line and a control gate of said corresponding access transistor is connected to a corresponding row line,
wherein in order to write a new data (T_n+1) in a target bit cell, said new data depending on a data (S_n) of a source bit cell (S) and on a data (T_n) stored by the target bit cell (T) before said writing,
the row driver (220, 420) simultaneously applies a first selecting voltage (V_s) to a first row line (222, 422) to select the target bit cell (210, 410, T), and a second selecting voltage (V_p-s) to a second row line (222', 422') to select the source bit cell (210', 410', S), and the column driver (230, 430) applies at the same time a logic current (I_imp) to at least one column line (232, 432),
**characterized in that**
the first selecting voltage is different from the second selecting voltage, such that when applied to the first and second row line respectively, the access transistor of the target bit cell has a lower resistance than the access transistor of the source bit cell.

12. Method according to claim 11, **characterized in that** the logic current (I_imp) has a higher amplitude than a critical current (I_H-to-L) required to switch the resistive-switching element (212, 412) of the target bit cell from a high resistance state to a low resistance state but small enough to prevent undesired switching events.

13. Method according to claim 12, **characterized in that** the ratio of the logical current (I_imp) to the critical current (I_H-to-L) is between 1 and 2.

14. Method according to claim 11 or 12, **characterized in that** the logic current (I_imp) is applied at a pulse duration that is long enough to enforce a desired switching event in the resistive-switching element (212, 412) of the target bit cell, but still short enough to prevent undesired switching events.

15. Method according to claim 14, **characterized in that** the logic current (I_imp) is applied at a pulse duration that is 2-3 orders of magnitude longer than the pulse duration of the critical current (I_H-to-L).

**Patentansprüche**

1. Elektronische Schaltung (200, 400), umfassend eine Vielzahl von Bitzellen (210, 410), die in einem Array angeordnet und durch Zeilenleitungen (222, 422) und Spaltenleitungen (232, 432) ansteuerbar sind, mindestens einen Zeilentreiber (220, 420), mindestens einen Spaltentreiber (230, 430) und eine Ausleseschaltung (260, 460), wobei jede Bitzelle (210, 410) einen Zugangstransistor (214, 414) und ein nichtflüchtiges Schaltwiderstandelement (212, 414) mit mindestens zwei Widerstandszuständen umfasst, wobei der Zugangstransistor und das nichtflüchtige Schaltwiderstandelement in Reihe mit einer entsprechenden Spaltenleitung verbunden sind und ein Steuergate des Zugangstransistors mit einer entsprechenden Zeilenleitung verbunden ist,
wobei zum Schreiben eines von einem Wert (S_n) einer Quellenbitzelle (S) und einem vor dem Schreiben durch die Zielbitzelle gespeicherten Wert (T_n) abhängenden neuen Wertes (T_n+1) in eine Zielbitzelle der Zeilentreiber (220, 420) in der Lage ist, gleichzeitig eine erste Ansteuerspannung (V_s) an eine erste Zeilenleitung (222, 422) zum Ansteuern der Zielbitzelle (210, 410, T) und eine zweite Ansteuerspannung (V_p-s) an eine zweite Zeilenleitung (222', 422') zum Ansteuern der Quellenbitzelle (210', 410', S) anzulegen, und der Spaltentreiber (230, 430) in der Lage ist, zur gleichen Zeit an mindestens eine Spaltenleitung (232, 432) einen Logikstrom (I_imp) anzulegen, **dadurch gekennzeichnet, dass**

sich die erste Ansteuerspannung von der zweiten Ansteuerspannung derart unterscheidet, dass, wenn diese an die erste bzw. zweiten Zeilenleitung angelegt sind, der Zugangstransistor der Zielbitzelle einen geringeren Widerstand aufweist als der Zugangstransistor der Quellenbitzelle.

2. Elektronische Schaltung (200, 400) nach Anspruch 1, **dadurch gekennzeichnet, dass** das Schaltwiderstandelement (212, 412) einen niederohmigen Zustand und einen hochohmigen Zustand aufweist.

3. Elektronische Schaltung (200, 400) nach einem der vorhergehenden Ansprüche, **dadurch gekennzeichnet, dass** das Schaltwiderstandelement (212, 412) eine bipolare Schalteigenschaft aufweist, so dass der Widerstandszustand der Schaltwiderstandelemente (212, 412) durch einen Strom- oder Spannungsimpuls in einer ersten Richtung von einem ersten Zustand in einen zweiten Zustand und durch einen Strom- oder Spannungsimpuls in der Gegenrichtung vom zweiten Zustand in den ersten Zustand geändert wird, wobei zum Umschalten ein Grenzstrom (I_H-zu-L) oder eine Grenzspannung angelegt werden muss.

4. Elektronische Schaltung nach Anspruch 3, **dadurch gekennzeichnet, dass** das Schaltwiderstandelement (212, 412) eine asymmetrische Schalteigenschaft aufweist und der Logikstrom (I_imp) die gleiche Polarität wie der zum Umschalten des Schaltwiderstandelements (212, 412) erforderliche Grenzstrom (I_H-zu-L) aufweist.

5. Elektronische Schaltung (200, 400) nach Ansprüchen 1 oder 2, **dadurch gekennzeichnet, dass** das Schaltwiderstandelement (212, 412) eine einpolige Schalteigenschaft aufweist, so dass der Widerstandszustand des Schaltwiderstandelements (212, 412) durch einen Strom oder eine Spannung mit einer ersten Amplitude von einem ersten Zustand in einen zweiten Zustand und durch einen Strom- oder Spannungsimpuls mit einer zweiten Amplitude vom zweiten Zustand in den ersten Zustand geändert wird, wobei zum Umschalten ein Grenzstrom (I_H-zu-L) oder eine Grenzspannung angelegt werden muss.

6. Elektronische Schaltung nach einem der Ansprüche 3 bis 5, **dadurch gekennzeichnet, dass** der Logikstrom (I_imp) eine Amplitude aufweist, die höher ist als der Grenzstrom (I_H-zu-L), um ein gewünschtes Schaltereignis im Schaltwiderstandelement (212, 412) der Zielbitzelle zu erzwingen, jedoch gering genug, um unerwünschte Schaltereignisse der Quellen- oder der Zielbitzelle zu verhindern.

7. Elektronische Schaltung nach Anspruch 6, **dadurch gekennzeichnet, dass** das Verhältnis des Logikstroms (I_imp) zum zum Umschalten des Schaltwiderstandelements (212, 412) erforderlichen Grenzstrom (I_H-zu-L) zwischen 1 und 2 beträgt.

8. Elektronische Schaltung nach einem der Ansprüche 3 bis 5, **dadurch gekennzeichnet, dass** der Logikstrom (I_imp) die gleiche Amplitude wie der Grenzstrom (I_H-zu-L) aufweist und mit einer Impulsdauer angelegt ist, die lange genug ist, um ein gewünschtes Schaltereignis im Schaltwiderstandelement (212, 412) der Zielbitzelle zu erzwingen, und kurz genug, um unerwünschte Schaltereignisse der Quellen- oder der Zielbitzelle zu verhindern.

9. Elektronische Schaltung nach Anspruch 8, **dadurch gekennzeichnet, dass** der Logikstromimpuls (I_imp) mit einer Impulsdauer angelegt ist, die 2 bis 3 Größenordnungen länger ist als die Impulsdauer des Grenzstroms (I_H-zu-L).

10. Elektronische Schaltung nach einem der vorhergehenden Ansprüche, **dadurch gekennzeichnet, dass** es sich bei den Schaltwiderstandelementen (212, 412) um magnetische Tunnelkontakt- (Magnetic Tunnel Junction, MTJ) Einrichtungen, bevorzugt um "Spin-Transfer-Torque- (STT)" MTJ-Einrichtungen, und bei den Zugangstransistoren (214, 414) um CMOS-Transistoren handelt.

11. Verfahren zum Durchführen der logischen Operation Subjunktion (IMP) oder negierte Subjunktion (NIMP) auf einem Speicherarray mit nichtflüchtigen Widerständen, das eine Vielzahl durch Zeilenleitungen (222, 422) und Spaltenleitungen (232, 432) ansteuerbarer Bitzellen (210, 410), wobei jede Bitzelle (210, 410) ein nichtflüchtiges Schaltwiderstandelement (212, 412) mit mindestens zwei Widerstandszuständen sowie einen Zugangstransistor (214, 414) umfasst, mindestens einen Zeilentreiber (220, 420), mindestens einen Spaltentreiber (230, 430) und eine Ausleseschaltung (260, 460) umfasst und wobei für jede Bitzelle (210, 410) der entsprechende Zugangstransistor und das nichtflüchtige Schaltwiderstandelement in Reihe mit einer entsprechenden Spaltenleitung verbunden sind und ein Steuergate des entsprechenden Zugangstransistors mit einer entsprechenden Zeilenleitung verbunden ist, wobei zum Schreiben eines von einem Wert (S_n) einer Quellenbitzelle (S) und einem vor dem Schreiben durch die Zielbitzelle gespeicherten Wert (T_n) abhängenden neuen Wertes (T_n+1) in eine Zielbitzelle der Zeilentreiber (220, 420) gleichzeitig eine erste Ansteuerspannung (V_s) an eine erste Zeilenleitung (222, 422) zum Ansteuern der Zielbitzelle (210, 410, T) und eine zweite Ansteuerspannung (V_p-s) an eine zweite Zeilenleitung (222', 422') zum Ansteuern der Quellenbitzelle (210', 410', S) anlegt, und der Spaltentreiber (230, 430) zur gleichen Zeit an mindestens eine Spaltenleitung (232, 432) einen Logikstrom (I_imp) anlegt,
**dadurch gekennzeichnet, dass**
sich die erste Ansteuerspannung von der zweiten Ansteuerspannung derart unterscheiden, dass, wenn diese an die erste bzw. zweite Zeilenleitung angelegt sind, der Zugangstransistor der Zielbitzelle einen geringeren Widerstand aufweist als der Zugangstransistor der Quellenbitzelle.

12. Verfahren nach Anspruch 11, **dadurch gekennzeichnet, dass** der Logikstrom (I_imp) eine höhere Amplitude aufweist als ein zum Umschalten des Schaltwiderstandelements (212, 412) der Zielbitzelle von einem hochohmigen Zustand in einen niederohmigen Zustand erforderlicher Grenzstrom (I_H-zu-L), jedoch gering genug, um unerwünschte Schaltereignisse zu verhindern.

13. Verfahren nach Anspruch 12, **dadurch gekennzeichnet, dass** das Verhältnis des Logikstroms (I_imp) zum Grenzstrom (I_H-zu-L) zwischen 1 und 2 beträgt.

14. Verfahren nach Anspruch 11 oder 12, **dadurch gekennzeichnet, dass** der Logikstrom (I_imp) mit einer Impulsdauer angelegt wird, die lange genug ist, um ein gewünschtes Schaltereignis im Schaltwiderstandelement (212, 412) der Zielbitzelle zu erzwingen, jedoch immer noch kurz genug, um unerwünschte Schaltereignisse zu verhindern.

15. Verfahren nach Anspruch 14, **dadurch gekennzeichnet, dass** der Logikstrom (I_imp) mit einer Impulsdauer angelegt wird, die 2 bis 3 Größenordnungen länger ist als die Impulsdauer des Grenzstroms (I_H-zu-L).

## Revendications

1. Circuit électronique (200,400) comprenant une pluralité de cellules binaires (210,410) agencées dans une matrice et étant sélectionnables par lignes de rangée (222,422) et lignes de colonne (232,432), au moins un pilote de rangée (220,420), au moins un pilote de colonne (230,430) et un circuit de lecture (260,460), dans lequel chaque cellule binaire (210,410) comprend un transistor d'accès (214,414) et un élément de commutation résistif non volatile (212,412) avec au moins deux états de résistance, ledit transistor d'accès et ledit élément de commutation résistif non volatile étant connectés en série à une ligne de colonne correspondante et une grille de commande dudit transistor d'accès est connectée à une ligne de rangée correspondante,
dans lequel afin d'écrire une nouvelle donnée (T_n+1) dans une cellule binaire cible, ladite nouvelle donnée dépendant d'une donnée (S_n) d'une cellule binaire source (S) et d'une donnée (T_n) mémorisée par la cellule binaire cible (T) avant ladite écriture, le pilote de rangée (220,420) est capable d'appliquer simultanément une première tension de sélection (V_s) à une première ligne de rangée (222,242) pour sélectionner la cellule binaire cible (210,410,T), et une seconde tension de sélection (V_p-s) à une seconde ligne de rangée (222',422') pour sélectionner la cellule binaire source (210',410',S) et le pilote de colonne (230,430) est capable d'appliquer au même moment un courant logique (I_imp) à au moins une ligne de colonne (232,432),
**caractérisé en ce que** la première tension de sélection est différente de la seconde tension de sélection, de sorte que lorsqu'appliquée à la première et la seconde ligne de rangée respectivement, le transistor d'accès de la cellule binaire cible a une résistance plus basse que le transistor d'accès de la cellule binaire source.

2. Circuit électronique (200,400) selon la revendication 1, **caractérisé en ce que** l'élément de commutation résistif (212,412) a un état de résistance bas et un état de résistance élevé.

3. Circuit électronique (200,400) selon une quelconque des revendications précédentes, **caractérisé en ce que** l'élément de commutation résistif (212,412) a une caractéristique de commutation bipolaire de sorte que l'état de résistance des éléments de commutation résistifs (212,412) soit changé d'un premier état à un second état par une impulsion de courant ou tension dans une première direction, et du second état au premier état par une impulsion de courant ou tension dans la direction opposée, où un courant critique (I_H-to-L) ou une tension critique doit être appliqué pour la commutation.

4. Circuit électronique selon la revendication 3, **caractérisé en ce que** l'élément de commutation résistif (212,412) a une caractéristique de commutation asymétrique et le courant logique (I_imp) a la même polarité que le courant critique (I_H-to-L) nécessaire pour commuter l'élément de commutation résistif (212,412).

5. Circuit électronique (200,400) selon les revendications 1 ou 2, **caractérisé en ce que** l'élément de commutation résistif (212,412) a une caractéristique de commutation unipolaire de sorte que l'état de résistance des éléments de commutation résistifs (212,412) soit changé d'un premier état à un second état par un courant ou une tension d'une première amplitude, et du second état au premier état par une impulsion de courant ou tension d'une seconde amplitude, où un courant critique (I_H-to-L) ou une tension critique doit être appliqué pour la commutation.

6. Circuit électronique selon une quelconque des revendications 3 à 5, **caractérisé en ce que** le courant logique (I_imp) a une amplitude plus élevée que le courant critique (I_H-to-L) pour mettre en oeuvre un évènement de commutation désiré dans l'élément de commutation résistif (212,412) de la cellule binaire cible mais assez petite pour empêcher des évènements de commutation indésirés de la cellule binaire source ou cible.

7. Circuit électronique selon la revendication 6, **caractérisé en ce que** le rapport du courant logique (I_imp) sur le courant critique (I_H-to-L) nécessaire pour commuter l'élément de commutation résistif (212,412) est entre 1 et 2.

8. Circuit électronique selon une quelconque des revendications 3 à 5, **caractérisé en ce que** le courant logique (I_imp) a la même amplitude que le courant critique (I_H-to-L) et est appliqué à une durée d'impulsion qui est assez longue pour mettre en oeuvre un évènement de commutation désiré dans l'élément de commutation résistif (212,412) de la cellule binaire cible et assez court pour empêcher des évènements de commutation indésirés de la cellule binaire source ou cible.

9. Circuit électronique selon la revendication 8, **caractérisé en ce que** l'impulsion de circuit logique (I_imp) est appliquée à une durée d'impulsion qui est 2-3 ordres de magnitude plus longue que la durée d'impulsion du courant critique (I_H-to-L).

10. Circuit électronique selon une quelconque des revendications précédentes, **caractérisé en ce que** les éléments de commutation résistifs (212,412) sont des dispositifs de jonction de tunnel magnétique (MTJ), de préférence des dispositifs MTJ à couple de transfert de spin (STT), et les transistors d'accès (214,414) sont des transistors CMOS.

11. Procédé pour effectuer l'opération logique d'implication matérielle (IMP) ou d'implication matérielle infirmée (NIMP) sur une matrice de mémoire résistive non volatile comprenant une pluralité de cellules binaires (210,410) étant sélectionnables par lignes de rangée (222,422) et lignes de colonne (232,432), dans lequel chaque cellule binaire (210,410) comprend un élément de commutation résistif non volatile (212,412) avec au moins deux états de résistance, et un transistor d'accès (214,414), au moins un pilote de rangée (220,420), au moins un pilote de colonne (230,430) et un circuit de lecture (260,460) et dans lequel, pour chaque cellule binaire (214,410), le transistor d'accès correspondant et l'élément de commutation résistif non volatile sont connectés en série à une ligne de colonne correspondante et une grille de commande dudit transistor d'accès correspondant est connectée à une ligne de rangée correspondante,
dans lequel afin d'écrire une nouvelle donnée (T_n+1) dans une cellule binaire cible, ladite nouvelle donnée dépendant d'une donnée (S_n) d'une cellule binaire source (S) et d'une donnée (T_n) mémorisée par la cellule binaire cible (T) avant ladite écriture, le pilote de rangée (220,420) applique simultanément une première tension de sélection (V_s) à une première ligne de rangée (222,242) pour sélectionner la cellule binaire cible (210,410,T), et une seconde tension de sélection (V_p-s) à une seconde ligne de rangée (222',422') pour sélectionner la cellule binaire source (210',410',S) et le pilote de colonne (230,430) applique au même moment un courant logique (I_imp) à au moins une ligne de colonne (232,432),
**caractérisé en ce que** la première tension de sélection est différente de la seconde tension de sélection, de sorte que lorsqu'appliquée à la première et la seconde ligne de rangée respectivement, le transistor d'accès de la cellule binaire cible a une résistance plus basse que le transistor d'accès de la cellule binaire source.

12. Procédé selon la revendication 11, **caractérisé en ce que** le courant logique (I_imp) a une amplitude plus élevée qu'un courant critique (I_H-to-L) nécessaire pour commuter l'élément de commutation résistif (212,412) de la cellule binaire cible d'un état de résistance élevé à un état de résistance bas mais assez petit pour empêcher des évènements de commutation indésirés.

13. Procédé selon la revendication 12, **caractérisé en ce que** le rapport du courant logique (I_imp) sur le courant critique (I_H-to-L) est compris entre 1 et 2.

**14.** Procédé selon la revendication 11 ou 12, **caractérisé en ce que** le courant logique (I_imp) est appliqué à une durée d'impulsion qui est assez longue pour mettre en oeuvre un évènement de commutation désiré dans l'élément de commutation résistif (212,412) de la cellule binaire cible, mais toujours assez court pour empêcher des évènements de commutation indésirés.

**15.** Procédé selon la revendication 14, **caractérisé en ce que** le courant logique (I_imp) est appliqué à une durée d'impulsion qui est 2-3 ordres de magnitude plus longue que la durée d'impulsion du courant critique (I_H-to-L).

Prior Art
Figure 1A

Prior Art
Figure 1B

Prior Art
Figure 2

Figure 3

$$T\_n+1 \longleftarrow T\_n \text{ NIMP } S\_n$$

| Case | Initial state | | Current | | Final state | |
|---|---|---|---|---|---|---|
| | Source (S_n) | Target (T_n) | Source | Target | Source (S_n+1) | Target (T_n+1) |
| 1 | HRS (1) | HRS (1) | I_S1<I_rd0 | I_T1>I_wr0 | HRS (1) | LRS (0) |
| 2 | HRS (1) | LRS (0) | I_S2<I_rd0 | —— | HRS (1) | LRS (0) |
| 3 | LRS (0) | HRS (1) | —— | I_T3<I_rd0 | LRS (0) | HRS (1) |
| 4 | LRS (0) | LRS (0) | —— | —— | LRS (0) | LRS (0) |

Figure 4A

Figure 4B

| | Current | Voltage | | |
|---|---|---|---|---|
| Step | Column Line | C | C' | C" |
| 1: TRUE | I_L-to-H | —— | —— | V_s |
| 2: NIMP | I_imp | V_p-s | —— | V_s |
| 3: NIMP | I_imp | —— | V_p-s | V_s |

Figure 5A

$$C''\_n{+}3 \leftarrow C\_n \; NOR \; C'\_n$$

| | Initial state | | Step 1 | Step 2 | Step 3 |
|---|---|---|---|---|---|
| Case | C_n | C'_n | C"_n+1 | C"_n+2 | C"_n+3 |
| 1 | HRS (1) | HRS (1) | HRS (1) | LRS (0) | LRS (0) |
| 2 | HRS (1) | LRS (0) | HRS (1) | LRS (0) | LRS (0) |
| 3 | LRS (0) | HRS (1) | HRS (1) | HRS (1) | LRS (0) |
| 4 | LRS (0) | LRS (0) | HRS (1) | HRS (1) | HRS (1) |

Figure 5B

$$T\_n{+}1 \longleftarrow S\_n \ IMP \ T\_n$$

| Case | Initial state | | Final state | |
|---|---|---|---|---|
| | Source (S_n) | Target (T_n) | Source (S_n+1) | Target (T_n+1) |
| 1 | HRS (0) | HRS (0) | HRS (0) | LRS (1) |
| 2 | HRS (0) | LRS (1) | HRS (0) | LRS (1) |
| 3 | LRS (1) | HRS (0) | LRS (1) | HRS (0) |
| 4 | LRS (1) | LRS (1) | LRS (1) | LRS (1) |

Figure 6A

$$C''\_n{+}3 \longleftarrow C\_n \ NAND \ C'\_n$$

| Case | Initial state | | Step 1 | Step 2 | Step 3 |
|---|---|---|---|---|---|
| | C_n | C'_n | C''_n+1 | C''_n+2 | C''_n+3 |
| 1 | HRS (0) | HRS (0) | HRS (0) | LRS (1) | LRS (1) |
| 2 | HRS (0) | LRS (1) | HRS (0) | LRS (1) | LRS (1) |
| 3 | LRS (1) | HRS (0) | HRS (0) | HRS (0) | LRS (1) |
| 4 | LRS (1) | LRS (1) | HRS (0) | HRS (0) | HRS (0) |

Figure 6B

400

Figure 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20050174837 A1
- US 7221600 B2
- US 7755930 B2
- US 8179716 B2
- EP 1557841 A2

### Non-patent literature cited in the description

- **M. HOSOMI et al.** A novel nonvolatile memory with spin torque transfer magnetization switching: spin-ram. *Proc. IEDM,* 2005